# EUROPÄISCHE PATENTSCHRIFT

(11) **EP 2 593 959 B1**
(45) Veröffentlichungstag und Bekanntmachung des Hinweises auf die Patenterteilung: **24.09.2014**
(21) Anmeldenummer: 11781429.3
(22) Anmeldetag: 07.07.2011
(51) Int. Cl.: H01J 37/32, C23C 16/52

(54) **ELEKTRODE ZUR ERZEUGUNG EINES PLASMAS, PLASMAKAMMER MIT DIESER ELEKTRODE UND VERFAHREN ZUR IN SITU ANALYSE ODER IN SITU BEARBEITUNG EINER SCHICHT ODER DES PLASMAS**
ELECTRODE FOR PRODUCING A PLASMA, PLASMA CHAMBER HAVING SAID ELECTRODE, AND METHOD FOR ANALYSING OR PROCESSING A LAYER OR THE PLASMA IN SITU
ELECTRODE SERVANT À PRODUIRE UN PLASMA, CHAMBRE À PLASMA AVEC CETTE ÉLECTRODE ET PROCÉDÉ D'ANALYSE IN SITU OU TRAITEMENT IN SITU D'UNE COUCHE OU DU PLASMA

(30) Priorität: 15.07.2010 DE 102010027224
(43) Veröffentlichungstag der Anmeldung: 22.05.2013
(73) Patentinhaber: Forschungszentrum Jülich GmbH, 52425 Jülich (DE)
(72) Erfinder: MUTHMANN, Stefan, 52074 Aachen (DE); GORDIJN, Aad, 3531 WH Utrecht (NL); CARIUS, Reinhard, 52428 Jülich (DE); HÜLSBECK, Markus, 52428 Jülich (DE); HRUNSKI, Dzmitry, 63741 Aschaffenburg (DE)
(86) Internationale Anmeldenummer: PCT/DE2011/001415
(87) Internationale Veröffentlichungsnummer: WO 2012/010146

(56) Entgegenhaltungen:
- WO-A1-2007/022144
- US-A1- 2004 118 518
- US-A1- 2005 029 228
- US-A1- 2006 196 846
- US-A1- 2009 163 034
- US-B1- 6 503 364

## Beschreibung

Die Erfindung betrifft eine Elektrode zur Erzeugung eines Plasmas, eine Plasmakammer mit dieser Elektrode und ein Verfahren zur in situ-Analyse oder -in situ-Bearbeitung einer Schicht oder des Plasmas.

Aus Li et al. (Li, Y.M., Ilsin A.N., Ngyuen H.V., Wronski C.R., Collins R.W. (1991). Real-Time-Spectroscopic Ellipsometry Determination of the Evolution of Amorphous-Semiconductor Optical Functions, Bandgap, and Micrsotructure. Journal of Non-Crystalline Solids. Vol. 137,787-790) ist die in situ Charakterisierung einer amorphen Schicht während der plasmaunterstützten chemischen Gasphasenabscheidung (engl. plasma enhanced chemical vapour deposition (PECVD) bekannt. Als Verfahren verwenden die Autoren eine Spektroskopische Ellipsometrie unter Einstrahlung von Licht im 70° Winkel. Nachteilig ist mit dem Verfahren und dem angewendeten Ellipsometer nur eine vergleichsweise begrenzte Aussage über die Schichteigenschaften möglich.

Wagner et al. (Wagner V., Drews, D., Esser, D.R., Zahn, T., Geurts, J., and W. Richter. Raman monitoring of semiconductor growth. J. Appl. Phys. 75, 7330) beschreiben eine in situ Raman Spektroskopie an einer mit Molekularstrahlepitaxie abgeschiedenen Schicht. Das Verfahren und der Aufbau der verwendeten Vorrichtung weisen den Nachteil auf, dass diese nicht uneingeschränkt von der Art des verwendeten Abscheidungsverfahrens angewendet werden können.

Aus Dingemans et al. (Dingemans, G.; van den Donker, M. N.; Hrunski, D.; Gordijn, A.; Kessels, W. M. M.; van de Sanden, M. C. M. (2007). In-Situ Film Transmittance Using the Plasma as Light Source: A Case Study of Thin Silicon Film Deposition in the Microcrystalline Growth Regime. Proceedings of the 22nd EUPVSEC (European Photovoltaic Solar Energy Conference), Milan/Italy, 03.09.2007 - 07.09.2007. - S. 1855 -1858) ist bekannt, eine optische Emissions-Spektroskopie am Plasma einer Plasmakammer in situ durchzuführen. Hierzu ist in der Gegenelektrode der Plasmakammer eine optische Durchführung vorhanden, mit der das Plasma direkt durch das Substrat hindurch untersucht werden kann. Nachteilig ist auch diese Vorrichtung nicht geeignet, weitergehende Informationen zum Verfahren zu sammeln.

Aus der US 2006/196846 A1 ist eine rf-Elektrode zur Erzeugung eines Plasmas in einer Plasmakammer bekannt, die mit mindestens einer optischen Durchführung ausgestattet ist, wobei die rf-Elektrode eine Gasdusche ist.
Aus der US 2005/029228 A1 ist ein optisches Detektionssystem bekannt, das in eine Elektrode integriert ist und eine zylindrische Durchführung aufweist.
Aus der WO 2007/022144 A1 ist eine Vorrichtung zur Verbesserung der optischen Abtastung von einem Plasmaprozess durch die Verwendung eines faseroptischen Sensors in einer Gasdusche bekannt. Das Licht wird durch eine Öffnung in der Gasdusche detektiert. Ein spezieller Schutz oder eine spezielle Ausgestaltung der Öffnung zum Schutz der optischen Elemente wird nicht offenbart.
Aus der US 2004/0118518 ist ein optisches Detektionssystem bekannt, welches ebenfalls in eine Gasdusche integriert ist. Um lokale unerwünschte Entladungen in der Öffnung zur optischen Messung zu vermeiden, sind im Bereich der optischen Durchführung eine Mehrzahl kleiner Löcher vorhanden.

Aufgabe der Erfindung ist es, eine Elektrode zur Erzeugung eines Plasmas in einer Plasmakammer bereit zu stellen, die sowohl unabhängig vom verwendeten Abscheidungsverfahren, wie z. B. PECVD, MOVPE, als auch unabhängig von der gewählten Untersuchungsmethode, wie z. B. die Raman Spektroskopie und die optische Emissionsspektroskopie, universell eingesetzt werden kann.

Eine weitere Aufgabe der Erfindung ist es, eine Plasmakammer bereit zu stellen, mit der unabhängig vom Herstellungsverfahren der Schicht eine Vielzahl an Untersuchungsmethoden in situ ermöglicht wird.

Eine weitere Aufgabe der Erfindung ist es, ein Verfahren anzugeben, mit dem die Analyse einer abzuscheidenden Schicht, als auch der Prozessgase während des laufenden Herstellungsverfahrens, in situ durchgeführt werden kann.

Die Aufgabe wird gelöst durch eine rf-Elektrode nach dem Hauptanspruch, eine Plasmakammer mit einer derartigen Elektrode und durch ein Verfahren nach den Nebenansprüchen. Vorteilhafte Ausgestaltungen ergeben sich aus den jeweiligen Unteransprüchen.

Es handelt sich erfindungsgemäß um eine rf-Elektrode für die Erzeugung des Plasmas mittels einer Hochfrequenzspannung. Das Plasma kann z. B. für die Abscheidung von Halbleiter-Schichten oder zur Plasmaätzung von Halbleiter-Schichten genutzt werden. Im ersten Falle werden Gase wie SiH₄ oder H₂, und im zweiten Fall ein Gas wie NF₃ in die Kammer geleitet.

Die rf-Elektrode ist erfindungsgemäß dadurch gekennzeichnet, dass sieb eine optische Durchführung umfasst. Die optische Durchführung gewährt vorteilhaft einen optischen Zugang sowohl auf den Plasmaraum selbst, als auch durch den Plasmaraum hindurch bis zum Substrat, welches auf der Gegenelektrode (auch Masseelektrode genannt) angeordnet ist. Der Durchtritt eines Strahlengangs durch die optische Durchführung der erfindungsgemäßen rf-Elektrode ist damit gewährt. Dadurch wird vorteilhaft bewirkt, dass sowohl die Analyse als auch die Bearbeitung des Substrats und der hierauf aufwachsenden Schicht während das Plasma brennt ermöglicht wird. Besonders vorteilhaft wird durch die Anordnung der optischen Durchführung in der rf-Elektrode bewirkt, dass in der Plasmakammer auch das Plasma selbst auf die Gaszusammensetzung hin untersucht und diese nachjustiert werden kann.

Dadurch wird eine weitgehende Freiheit bei der Wahl der Untersuchungsmethode und Bearbeitungsmethode erreicht.

Im Rahmen der Erfindung wurde erkannt, dass der Stand der Technik, sowohl in Hinblick auf die Anordnung einer optischen Durchführung in der Gegenelektrode bei Dingemans et al., als auch mit Blick auf die angewendeten Untersuchungsverfahren in Li et al. sowie der Abscheidungsverfahren in Wagner et al., limitiert sind. Nur die erfindungsgemäße rf-Elektrode gewährleistet, dass bei mehr oder weniger jedem Abscheidungsverfahren (PECVD, MOVPE und andere) in situ verschiedenste Untersuchungs- oder Bearbeitungsschritte der Schicht sowie auch des Plasmas ermöglicht werden. Das erfindungsgemäße Verfahren nutzt durch den Rückgriff auf die erfindungsgemäße rf-Elektrode sowohl für den Eintritt in den Plasmaraum, als auch für den Austritt elektromagnetischer Strahlung, einen Einfallswinkel von etwa Null Grad zur abzuscheidenden Schicht. Dadurch wird vorteilhaft bewirkt, dass auch Raman Spektroskopie an einer wachsenden Schicht oder lokal aufgelöste, optische Emissionsspektroskopie am Plasma während das Plasma brennt (in situ) durchgeführt werden kann. Die Bearbeitung der Schicht kann einen Bearbeitungsschritt mit einem Laser umfassen.

Besonders vorteilhaft wird durch die optische Durchführung in der rf-Elektrode bewirkt, dass eine direkte Beobachtung einer Schicht durch Ein- und Auskopplung des Lichts mit einem Einfallswinkel von etwa Null Grad zur Schicht ermöglicht wird. Geringfügige Abweichungen vom Null Grad Einfallswinkel sind denkbar.

Im Stand der Technik wird hingegen im 70° Winkel zur Schicht der Strahlengang zur Analyse der Schicht eingestrahlt. Dies hat den Nachteil, dass ein großer Teil des Abscheidungsraumes in der Plasmakammer mitbetrachtet und fälschlich auch analysiert und interpretiert wird. Im Rahmen der Erfindung wurde erkannt, dass diese Form der in situ-Analyse fehlerbehaftete Ergebnisse bei der Interpretation der Schichteigenschaft oder der Plasmaeigenschaft lieferte.

Es wurde zudem erkannt, dass bisher, vor allem bei kleinen Elektrodenabständen relativ zur Elektrodenfläche, nur die Analyse eines Randbereichs der Schicht oder aber nur unter einem bestimmten Winkel auch der produktionsrelevante Teil analysiert werden konnte. Viele Untersuchungen, wie die Raman Spektroskopie, können im Stand der Technik wie in Dingemans et al., aber erst nach der Abscheidung durchgeführt werden. Mit Randbereich der Schicht wird der Teil der wachsenden Schicht bezeichnet, der außerhalb des optimalen Nutzungsbereichs der Elektrode liegt, bzw. der für die spätere Anwendung der Schicht irrelevant ist. Dadurch sind bestimmte Messmethoden, wie z. B. die Raman Spektroskopie oder die Reflexionsspektroskopie, als besonders einträgliche Verfahren zur Charakterisierung einer abgeschiedenen Schicht in Echtzeit, das heißt noch während der Abscheidung, ausgeschlossen. Der Begriff in situ der vorliegenden Patentanmeldung meint also die Analyse oder Bearbeitung des Substrats oder einer hierauf angeordneten oder abzuscheidenden Schicht während das Plasma brennt, das heißt in Echtzeit.

Im Gegensatz zu dem Stand der Technik können mit der erfindungsgemäßen rf-Elektrode auch produktionsrelevante Bereiche der Schicht in Echtzeit analysiert und bearbeitet werden, und nicht nur die Randbereiche.

Als Analyse gilt insbesondere die in situ Raman Spektroskopie. Durch Einkoppeln eines gepulsten Laserstrahls durch die optische Durchführung der rf-Elektrode hindurch auf die Schicht und durch Spektroskopie des gestreuten Lichts in der direkten Rückreflexion kann während einer Abscheidung, z. B. von Material für eine Dünnschichtsolarzelle, eine Raman Spektroskopie durchgeführt werden. Dadurch ist es möglich, das Wachstum und die strukturellen Eigenschaften der Schicht während der Abscheidung besser zu überwachen.

Als Analyse gilt auch die ortsaufgelöste Emissionsspektroskopie. Mit Hilfe eines konfokalen Aufbaus mit einer fixiert angeordneten oder verschiebbaren Linse im Strahlengang, können die Plasma Emissionen über einer wachsenden Siliziumoberfläche ortsaufgelöst, das heißt in unterschiedlichen Abständen von der Oberfläche der Schicht, spektroskopiert werden. Die Linse kann fixiert an der rf-Elektrode angeordnet werden. Die Linse kann aber auch im Gehäuse der Plasmakammer fixiert werden. Die Linse kann aber auch im Gehäuse verschiebbar angeordnet werden, so dass ein für unterschiedliche Anwendungen konfokaler Messplatz erreicht wird. Es sind andere Verfahren wie die Reflexionsspektroskopie anwendbar. Es kann zudem zum selben Zweck die rf-Elektrode mit hieran fixierter Linse im Strahlengang des Messplatzes verschiebbar zur untersuchenden Schicht angeordnet werden.

Die optische Durchführung verläuft durch die rf-Elektrode hindurch von einer Seite der Oberfläche auf die dieser Seite gegenüberliegende Seite der rf-Elektrode. Mit Durchführung ist im Sinne der Erfindung also eine Öffnung durch die Konstruktion der Elektrode umfasst, die den Durchtritt von elektromagnetischer Strahlung, insbesondere Laserstrahlung zur Abtastung in Richtung der wachsenden Schicht, gewährleistet. Die optische Durchführung gewährleistet andererseits den Durchtritt der von der Schicht oder dem Plasma ausgehenden Strahlung (z. B. Reflektion, Streuung oder Wärmestrahlung) zurück auf ein Analysegerät. Auch Temperaturmessungen der Schicht sind gewährleistet. Die Elektrode mit der optischen Durchführung ist demnach im Strahlengang der in die Plasmakammer eingekoppelten Strahlung angeordnet.

Die Elektrode ist besonders vorteilhaft in eine Plasmakammer integriert, in der ein Vakuum erzeugt werden kann. Die Elektrode ist von der Kammerwand elektrisch isoliert. Die rf-Elektrode ist mit einer Anschlussmöglichkeit für eine Hochfrequenz Wechselspannung (rf-Anschluss: 30 kHz-300 GHz Oszillation, vorzugsweise 13,56 MHz bis 108,48 MHz) versehen. Die Wechselspannung eines rf-Generators wird an die Metallplatte als Elektrode angelegt, die sich in einer Niederdruckkammer befindet. Parallel zur rf-Elektrode und dieser gegenüberliegend ist die Gegenelektrode mit dem Substrathalter angeordnet.

Die Vakuumkammer enthält vorteilhaft ein Fenster als eine optische Durchführung in ihrer Wand, durch das die elektromagnetische Strahlung ein- und wieder ausgekoppelt werden kann.

Die aus der Plasmakammer ausgekoppelte Strahlung wird vorteilhaft durch das Linsen- und gegebenenfalls auch Spiegelsystem geführt und auf den Eintrittsspalt eines Spektrographen, wie z. B. eines Oriel Instruments MS260, fokussiert. Mithilfe des Spektrographen wird die Strahlung in ihre spektroskopischen Bestandteile zerlegt, die mittels einer CCD Kamera, z. B. einer Andor iDus 420, analysiert werden. Im Falle einer Raman Spektroskopie ist in den optischen Weg von der Substratoberfläche zum Spektroskop ein optischer Kerbfilter angeordnet. Der Kerbfilter bewirkt vorteilhaft, dass die zur Anregung der Raman Streuung genutzte Wellenlänge mit sehr schmaler Bandbreite unterdrückt wird.

Der optische Zugang zur Schicht bzw. zum Plasma über der Schicht ist im einfachsten Fall ein Loch, vorzugsweise in der Mitte oder in der Nähe der Mitte der rf-Elektrode, so dass produktionsrelevante Teile des Substrats, bzw. der abzuscheidenden Schicht, analysiert oder bearbeitet werden können. Auch dies ist mit Elektroden nach dem Stand der Technik nicht möglich.

Die rf-Elektrode weist besonders vorteilhaft eine optische Durchführung auf, welche zur Plasmakammer gerichtet geschirmt ist. Die Schirmung erfolgt vorzugsweise mit einem metallischen Gitter, welches auf der Öffnung der optischen Durchführung angeordnet ist. Dadurch wird vorteilhaft bewirkt, dass das von der Elektrode erzeugte elektrische Feld nicht gestört wird.

Im Rahmen der Erfindung wurde erkannt, dass die optische Durchführung abhängig von den Parametern des verwendeten Abscheidungsverfahren zu Inhomogenitäten in der Schichtabscheidung oder während einer Ätzung aufgrund eines gestörten elektrischen Feldes führten kann. Deshalb wurde die optische Durchführung der rf-Elektrode zum Plasmaraum hin, vorzugsweise durch ein Metallgitter, so geschirmt, dass ein optischer Zugang mit kleinen Verlusten möglich ist. Dadurch wird vorteilhaft bewirkt, dass das von den Elektrodenplatten erzeugte Hochfrequenzfeld weitestgehend unbeeinflusst durch die optische Durchführung ist.

Dies gilt insbesondere für den besonders vorteilhaften Fall, dass die optische Durchführung Bestandteil einer Gasduschenelektrode als rf-Elektrode (engl. Showerhead-Elektrode) ist.

In diesem Fall ist die optische Durchführung in der Gasduschenelektrode als rf-Elektrode integriert, so dass die Homogenität der Gasverteilung nicht gestört ist. Dies gelingt durch die Wahl eines Standorts für die optische Durchführung, bei dem nur wenige oder bestenfalls gar keine Löcher für den Gasdurchtritt durch die optische Durchführung beeinflusst werden.

Die optische Durchführung und das metallische Gitter als Schirmung können aus demselben Material bestehen, z. B. aus VA-Stahl oder Aluminium.

Das Gitter als Schirmung kann vorzugsweise durch Laserstrahlschneiden hergestellt werden. Die Dicke der Gitterstege kann etwa 0,3 mm betragen und die Stegbreite z. B. etwa 0,1 mm. Die Öffnung der optischen Durchführung kann vorzugsweise zu 12 bis 19 % durch die Stege der Schirmung bedeckt sein. Eine Bedeckung der Öffnung durch die Schirmung zu etwa 10 % sollte genug sein, um die Homogenität des Plasmas zu erhalten. Eine optimale Schirmung bekäme man auch durch eine Metallplatte, durch die aber selbstverständlich keine Analysen oder Bearbeitungsschritte des Substrats oder des Plasmas möglich sind. Auch mit weniger als 10 % an bedeckter Oberfläche der Öffnung der optischen Durchführung ist eine Schirmung grundsätzlich möglich. Die genaue prozentuale Bedeckung der Öffnung der optischen Durchführung durch die Schirmung hängt von den Prozessbedingungen, z. B. vom eingesetzten Druck in der Plasmakammer, ab. Bei einem Druck von >18 Torr, einem Elektrodenabstand von 9 mm, einer Leistungsdichte von ∼1 W/cm² und einer Wachstumsrate von 0,5 nm/s ist bei der Abscheidung von mikrokristallinem Silizium, bei einem dem Substrat zugewandten Lochdurchmesser von 1 cm, gar keine Schirmung der optischen Durchführung nötig.

Bei einem Druck von 10 Torr, einem Elektrodenabstand von 9 mm, einer Leistungsdichte von 0,6 W/cm² und einer Wachstumsrate von 0,5 nm/s sollte bei der Abscheidung von mikrokristallinem Silizium, bei einem dem Substrat zugewandten Lochdurchmesser von 1 cm, etwa 10 % der Öffnung der optischen Durchführung durch die Schirmung bedeckt sein.

In der erfindungsgemäßen Plasmakammer ist im Falle einer Schirmung die zur Abscheidungszone gerichtete Öffnung der optischen Durchführung geschirmt. Als Plasmakammer bezeichnet man üblicherweise die ganze Vakuumkammer.

Die optische Durchführung muss allgemein so groß sein, dass durch die erfindungsgemäße Elektrode hindurch das angestrebte Untersuchungsverfahren ermöglicht wird. Dies kann z. B. eine in situ Raman Spektroskopie oder eine optische Emissionsspektroskopie, oder z. B. die Bestimmung der Gaskonzentrationen auf optischem Weg sein. Die Fläche der optischen Durchführung sollte etwa mindestens 0,03cm² betragen. Bei kreisrunden optischen Durchführungen entspricht dies einem Durchmesser der zur Abscheidungszone gerichteten Öffnung von mehr als 2 mm. Vorzugsweise weist die Öffnung eine Fläche von 1 bis 10 cm² auf.

Eine Linse kann an der rf-Elektrode oder allgemein in der Plasmakammer angeordnet sein. Die Linse soll für ein erfindungsgemäßes Verfahren die elektromagnetische Strahlung durch die optische Durchführung hindurch auf das Plasma oder die Schicht bzw. das Substrat fokussieren. Dieselbe Linse oder, je nach Einfallswinkel der Strahlung, eine Linse einer weiteren optischen Durchführung in der rf-Elektrode parallelisiert die von dem Substrat oder vom Plasma durch die optische Durchführung hindurch reflektierte oder gestreute oder emittierte elektromagnetische Strahlung.

Vorzugsweise beträgt der Einfallswinkel der elektromagnetischen Strahlung auf das Substrat bzw. die Schicht Null Grad. Eine geringe Abweichung hiervon ist möglich, so dass für den Zugang zum produktionsrelevanten Teil der Schicht bzw. der Entladungszone ein kleinerer Einfallswinkel möglich ist, als bei einem Zugang durch den Raum seitlich zwischen den Elektroden.

Die Größe der optischen Durchführung ist also keineswegs mit der Größe der Öffnungen der Löcher in einer Gasduschenelektrode nach dem Stand der Technik zu verwechseln und daher auch nicht hiermit zu vergleichen. Diese haben üblicherweise einen Durchmesser von nur etwa 0,8 mm entsprechend etwa 0,005 cm² Fläche. Diese Öffnungen nach dem Stand der Technik sind ungeeignet für eine erfindungsgemäße Analyse oder Bearbeitung der Schicht oder des Plasmas auf optischen Weg.

Die optische Durchführung führt vollständig durch die Elektrode hindurch. Somit weist die Elektrode eine erste Öffnung auf der einen Seite der Oberfläche und eine zweite Öffnung auf der dieser Oberfläche gegenüberliegenden Oberfläche der Elektrode auf. Beide Öffnungen der optischen Durchführung können den gleichen Durchmesser aufweisen. Dann ist die erfindungsgemäße Elektrode besonders leicht herstellbar.

Die optische Durchführung weist einen konischen Schnitt auf. Die optische Durchführung ist konisch in der Elektrode angeordnet. In der konischen Durchführung weist die zum Plasmaraum gerichtete Öffnung eine größere Fläche auf, als die dieser Öffnung gegenüberliegende Öffnung der optischen Durchführung. Vorteilhaft wird dann bewirkt, dass elektromagnetische Strahlung von der Schicht oder dem Plasma ausgehend effizienter gesammelt und dem Analysegerät zugeführt werden kann.

Es wurde erkannt, dass im einfachsten Falle die optische Durchführung durch ein einzelnes z. B. zylinderförmiges Loch in der Elektrode realisiert werden kann. Es kann z. B. mit einem 10 mm Bohrer die rf-Elektrode durchbohrt werden. Es ist aber auch möglich, stattdessen mit einem Senker eine konische Durchführung in die rf-Elektrode einzubringen.

Die kleinere der beiden Öffnungen einer konischen optischen Durchführung kann eine Fläche von 0,03 cm² bis 5 cm² aufweisen. Die größere der beiden Öffnungen der konischen optischen Durchführung kann eine Fläche von 0,031 bis 100 cm² aufweisen. Besonders vorteilhaft ist die Fläche der größeren Öffnung der optischen Durchführung bis 20 mal größer.

Allgemein hängt die Größe der Öffnung, welche vom Substrat abgewandt ist bei gegebenem Winkel des Konus von der Dicke der erfindungsgemäßen Elektrode ab.

Vorzugsweise strömt durch die optische Durchführung kein Gas oder genauso viel Gas wie aus einer gleich großen Fläche einer unmodifizierten Gasduschenelektrode in den Plasmaraum. Dadurch wird vorteilhaft bewirkt, dass die Homogenität des Gasflusses durch die optische Durchführung nicht gestört wird.

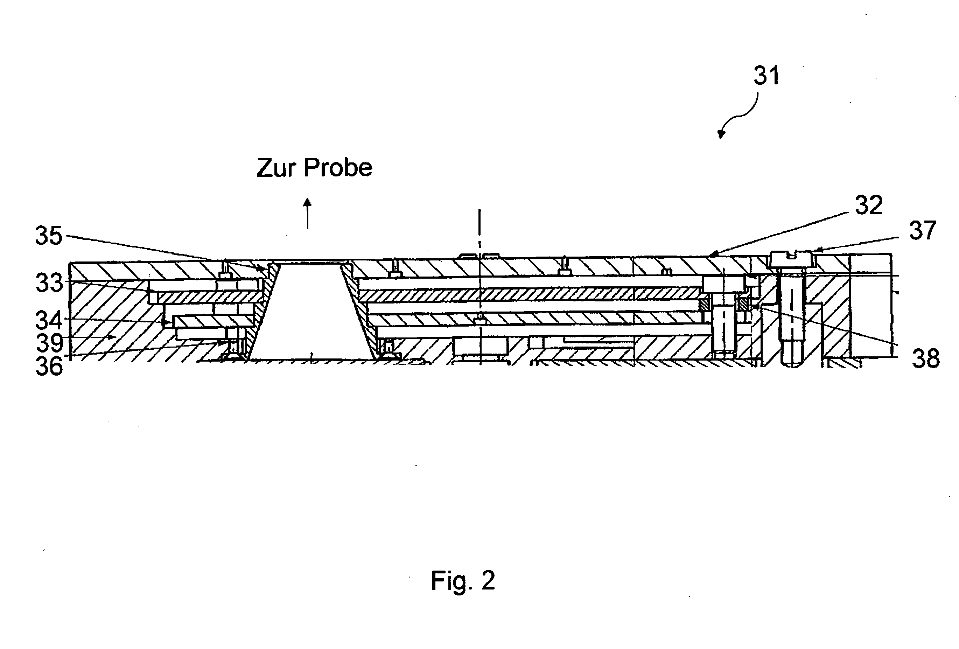

Eine optische Durchführung kann zusätzlich zu einem einfachen Loch in der Elektrode durch ein Bauteil ausgebildet werden. Diese kleidet das Loch in der Elektrode hülsenartig aus. In einer Gasduschenanordnung als rf-Elektrode sind beispielweise drei Gasverteilerplatten unterschiedlichen Durchmessers übereinander angeordnet, wie z. B. in Figur 2 gezeigt. Diese bilden die erfindungsgemäße Gasdusche als rf-Elektrode aus. In den drei Gasverteilerplatten ist jeweils ein Loch unterschiedlicher Größe zur Ausbildung der optischen Durchführung angeordnet. In der Elektrode sind diese übereinander angeordnet, so dass eine konische optische Durchführung gebildet wird. In der Gasdusche ist zusätzlich ein trichterförmiges konisches Bauteil für die Ausbildung der konischen optischen Durchführung angeordnet. Dieses Bauteil kleidet die optische Durchführung von innen aus. Der Trichter weist hierzu stufenförmige Auflageflächen für die Gasverteilerplatten auf. Haltemittel, wie Schrauben, befestigen die Platte(n) an dem Trichter. Durch die Wand des trichterförmigen Bauteils wird vorteilhaft ein Einströmen des Gases in den Plasmaraum durch die optische Zuführung verhindert. Der Trichter sorgt hier für Gasdichtigkeit der optischen Durchführung.

Auch hier kann, abhängig von den Parametern des Abscheidungsverfahrens, ein Metallgitter als Schirmung auf der kleineren Öffnung des trichterförmigen Bauteils angeordnet sein.

In einer weiteren Ausgestaltung der Erfindung ist an der optischen Durchführung der rf-Elektrode eine konvexe, insbesondere eine plankonvexe Sammellinse fixiert angeordnet. Diese bewirkt vorteilhaft, dass zu Analysezwecken oder zu Bearbeitungszwecken elektromagnetische Strahlengang durch die optische Durchführung hindurch auf das Substrat bzw. die aufwachsende Schicht oder in das Plasma geleitet und auf dessen Oberfläche fokussiert wird. Hierdurch ist es möglich, durch den hohen Energieeintrag eines gepulsten Lasers eine Raman Emission des Substrats bzw. der Schicht hervorzurufen und somit eine Raman Spektroskopie an der zurückgeworfenen Strahlung durchzuführen. Außerdem kann das Licht oder allgemein die elektromagnetische Strahlung mithilfe der Linse gesammelt und fokussiert und auch parallelisiert werden.

Die Linse ist dann auf der nicht zum Plasmaraum ausgerichteten Seite der optischen Durchführung angeordnet. Im Falle einer zusätzlich vorhandenen Schirmung ist die Linse entsprechend auf einer Seite der Öffnung, welche der Schirmung gegenüberliegt, angeordnet.

Besonders bevorzugt ist zwischen der Sammellinse und der Öffnung der optischen Durchführung ein austauschbares Glasplättchen zum Schutz der Sammellinse angeordnet. Dadurch wird vorteilhaft bewirkt, dass die Linse nicht beschichtet wird während das Plasma brennt. Dadurch wird vorteilhaft bewirkt, dass bei einer Reinigung der Kammer die Linse nicht ausgebaut werden muss. Somit muss die Optik vorteilhaft nach der Reinigung nicht neu justiert werden.

Eine erfindungsgemäße Plasmakammer umfasst die rf-Elektrode mit einer oder mehreren optischer Durchführungen und einem rf-Hochfrequenzanschluss.

In der Kammer ist eine geerdete oder schwebende Gegenelektrode mit einem darauf angeordneten Substrat angeordnet. Zwischen der Elektrode und der Gegenelektrode wird ein Hochfrequenzwechselfeld zur Erzeugung des Plasmas ausgebildet. Die Kammer weist erfindungsgemäß die rf-Elektrode mit der optischen Durchführung auf. Dadurch wird vorteilhaft bewirkt, dass elektromagnetische Strahlung durch die optische Durchführung auf das Substrat bzw. die darauf wachsende Schicht oder in das Plasma selbst gerichtet werden kann. Dadurch kann das Substrat, die Schicht oder die Gaszusammensetzung in der Kammer während der Abscheidung und während das Plasma brennt, in situ untersucht werden.

Die zum Innem der Plasmakammer ausgerichtete Öffnung der optischen Durchführung ist vorteilhaft geschirmt, so dass eine besonders homogene Abscheidung oder Ätzung der auf dem Substrat angeordneten Schicht erzeugt wird.

Eine konvexe Sammellinse auf der der Plasmakammer abgewandten Seite der optischen Durchführung fokussiert den Strahlengang auf das Substrat bzw. auf die auf dem Substrat aufwachsende Schicht oder auf das Plasma selbst. Die Linse sammelt, fokussiert und parallelisiert die reflektierte oder gestreute oder von der Probenoberfläche ausgehende Strahlung der Schicht zum Zwecke der Analyse. Das heißt, die von der Schicht reflektierte oder gestreute oder emittierte Strahlung wird wiederum durch die optische Durchführung auf dem Rückweg gesammelt und aus der Plasmakammer herausgeleitet.

Die erfindungsgemäße rf-Elektrode und die erfindungsgemäße Kammer ermöglichen im Sinne einer einheitlichen Idee somit ein Verfahren zur in situ-Analyse oder in situ-Bearbeitung einer Schicht in der Plasmakammer sowie auch des Plasmas, während dieses brennt. Das Substrat ist auf der Gegenelektrode angeordnet.

Auf der dem Substrat zugewandten Seite wird in einem Abstand X zum Substrat die rf-Elektrode angeordnet. Die zur Abscheidung oder Ätzung verwendeten Prozessgase werden eingelassen und der Prozessdruck eingestellt. Sodann wird das Plasma gestartet.

Für das Verfahren wird in einer Ausgestaltung der Erfindung eine Elektrode mit einer optischen Durchführung gewählt, welche auf der dem Substrat zugewandten Seite der Elektrode eine Schirmung aufweist. Besonders vorteilhaft wird auf der der Schirmung gegenüber liegenden Seite der Elektrode eine plankonvexe Sammellinse angeordnet.

Vorzugsweise wird eine Sammellinse gewählt, die eine Brennweite X plus die Dicke der Elektrode aufweist. Dadurch wird vorteilhaft bewirkt, dass ein durch die optische Durchführung hindurch tretender Strahlengang auf das Substrat fokussiert wird. Reflektierte oder gestreute oder von der Schichtoberfläche emittierte Strahlung wird durch die Linse hingegen gesammelt und parallelisiert aus der Kammer geleitet. Zu diesem Zweck kann die reflektierte oder gestreute oder von der Schichtoberfläche emittierte Strahlung zunächst je nach Aufbau der Analysevorrichtung und Platzangebot auf einen Spiegel geleitet werden.

Besonders bevorzugt ist die Plasmakammer mit einer Verstellbarkeit der Sammellinse entlang des Strahlengangs. Hierzu wird die Linse im Gehäuse der Plasmakammer verschiebbar befestigt. Eine Plasmakammer mit einem Halter wird gewählt, welcher höhenverstellbar an der Elektrode befestigt ist. Die Linse kann auch an der rf-Elektrode fixiert sein und die Elektrode selbst ist verschiebbar. Mit beiden Aufbauten wird vorteilhaft bewirkt, dass verschiedene Bereiche zwischen der rf-Elektrode und der Schicht sowie die Schicht als auch das Plasma selbst variabel spektroskopiert werden können. Die Höhenverstellbarkeit kann durch eine Schraube in einem Langloch gewährleistet werden.

Dadurch kann das System während des Verfahrens an verschiedene Linsen- und Elektrodenabstände angepasst werden. Außerdem wird auf diese Weise die Untersuchung der aufwachsenden Schicht als auch des Plasmas ermöglicht. Selbstverständlich kann für das Verfahren aber auch die Sammellinse an der Elektrode selbst befestigt werden.

Vorzugsweise wird eine in situ-Raman Spektroskopie durch Sammeln von Phononen mittels der Sammellinse durchgeführt, wobei die Linse das zum Substrat gerichtete Licht auf die zu untersuchende Schicht fokussiert, und die von der Schicht reflektierte oder gestreute oder von der Schichtoberfläche emittierte Strahlung parallelisiert aus der Kammer leitet.

Mit dem Begriff Schicht ist erfindungsgemäß auch das Substrat selbst gemeint.

Im Weiteren wird die Erfindung anhand von Ausführungsbeispielen und der Figuren näher beschrieben, ohne dass hierdurch eine Einschränkung der Erfindung stattfindet.

Es zeigen:
- Figur 1:: Schnitt durch die erfindungsgemäße rf-Elektrode und Plasmakammer (Schemazeichnung).
- Figur 2:: Schnitt durch die erfindungsgemäße Gasduscheelektrode (technische Zeichnung).
- Figur 3:: Schnitt durch die erfindungsgemäße Plasmakammer (Schemazeichnung).
- Figur 4:: Schnitt durch die erfindungsgemäße Plasmakammer (technische Zeichnung).
- Figur 5:: Durch den erfindungsgemäßen Aufbau aus rf-Elektrode mit optischer Durchführung und Anordnung in der Plasmakammer erfolgte in situ-Messung der Intensität der Stokes-Verschiebung in Abhängigkeit von der Größe der Verschiebung als Basis einer Raman Spektroskopie.
- Figur 6:: Durch den erfindungsgemäßen Aufbau aus Elektrode mit optischer Durchführung und Anordnung in der Plasmakammer erfolgte in situ Messung der Wellenlänge in Abhängigkeit von der Intensität als Basis für die Bestimmung der SiH₄-Konzentration in der Plasmakammer.

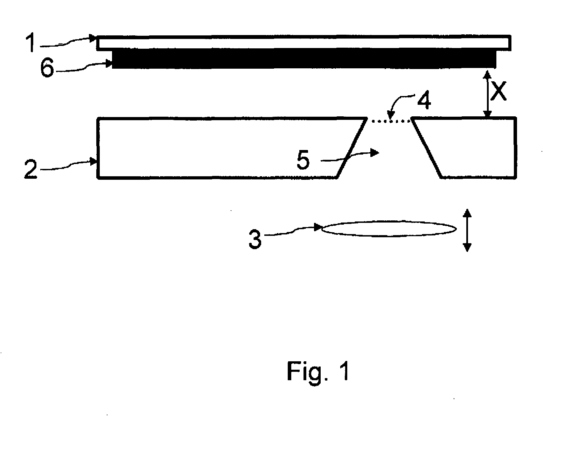

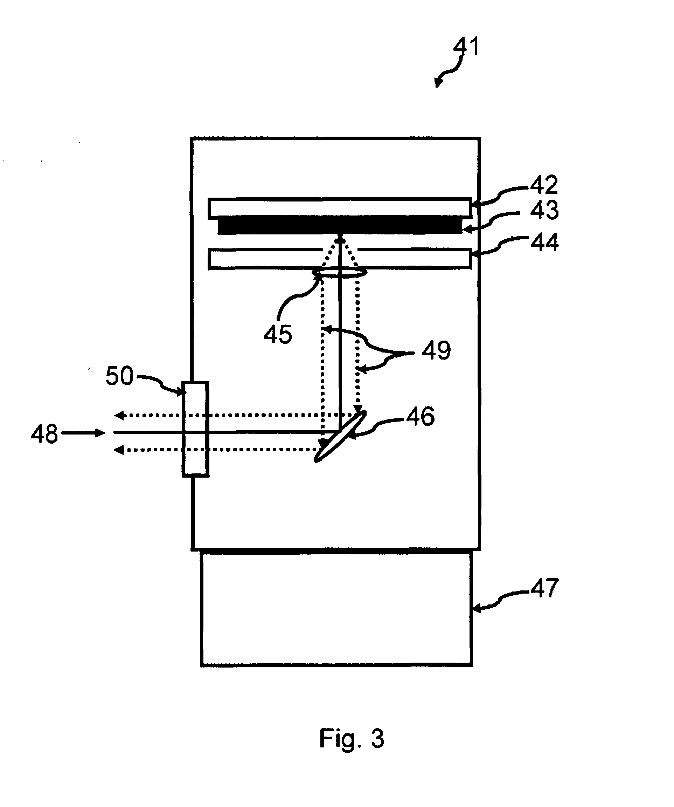

Figur 1 zeigt das Prinzip der Lösung der Aufgabe der Erfindung durch eine optische Durchführung. An der Elektrode 1, der Gegenelektrode, ist das Substrat 6 angeordnet. Die erfindungsgemäße rf-Elektrode 2 weist die optische Durchführung auf, die groß genug ist eine Analyse oder Bearbeitung des Substrats oder des Plasmas in situ vorzunehmen. Der Strahlengang wird hierzu im Null Grad Einfallswinkel zum Substrat auf dieses geleitet und durch die Linse fokussiert. Der Bereich der optischen Durchführung ist mit Bezugszeichen 5 angegeben. Der Konus der Durchführung 5 mit der kleineren Öffnung zum Substrat gerichtet bewirkt vorteilhaft, dass mehr Rückstrahlung vom Substrat durch die Linse eingesammelt werden kann, als im Falle einer einfachen Lochdurchführung wie in Figur 3. Auf der dem Substrat zugewandten Seite der Durchführung 5 ist das metallische Schirmgitter 4, dargestellt durch die gepunktete Linie, angeordnet. Die Schirmung kann zu diesem Zweck in eine Nut in der optischen Durchführung eingelötet werden. Bezugszeichen 3 gibt eine im Halter der Plasmakammer höhenverstellbare Sammellinse an.

Figur 2 zeigt im Schnitt eine erfindungsgemäße Gasduschenelektrodenanordnung mit drei Gasverteilerplatten, die in einer Halterung 39 aus VA-Stahl eingepasst sind. Es ist im Schnitt eine erste Gasverteilerplatte 32, die zum Substrat (in der Figur nicht dargestellt, aber oberhalb der Elektrode 31 gedanklich anzuordnen) ausgerichtet zu sehen. Diese ist mit zwei Schrauben 37 an der Halterung befestigt. Eine zweite Gasverteilerplatte 33 und eine dritte Gasverteilerplatte 34. sind durch Abstandsringe 38 voneinander getrennt. Der Durchmesser der Gasverteilerplatten nimmt von Gasverteilerplatte 32 bis nach Gasverteilerplatte 34 kontinuierlich zu. Das Loch in Platte 32 hat einen Innendurchmesser von 10 mm, das in Platte 33 16 mm und das in Platte 34 19 mm.

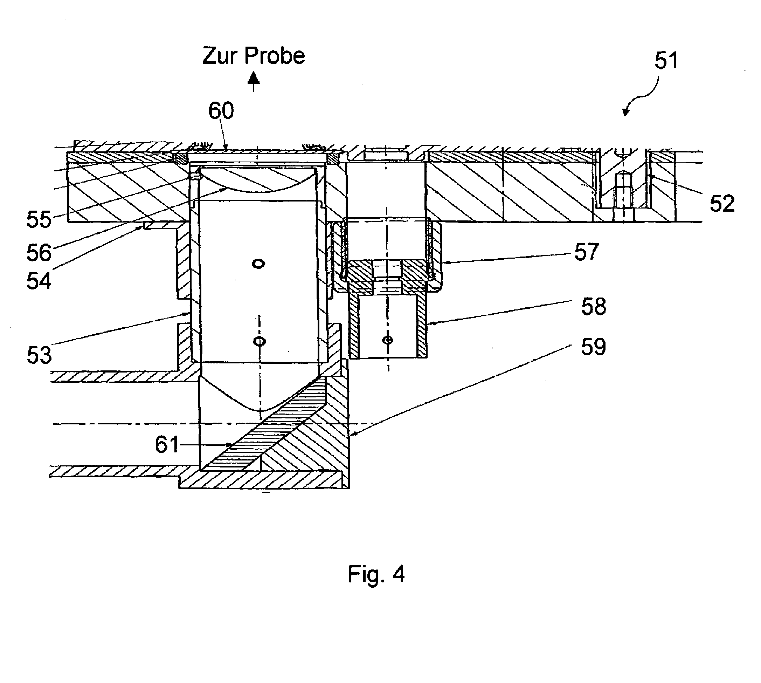

Mit Bezugszeichen 35 ist ein stufenförmiger Trichter als physisch vorhandenes Bauteil bezeichnet. Der Trichter 35 hat randständige, nach außen gerichtete Stufen, auf die die Gasverteilerplatten 32, 33 und 34 aufgelegt sind. Am unteren Ende des Trichters ist eine Überwurfkante angeordnet, die in ihrem Rand zwei oder mehr Bohrungen trägt. Die Bohrungen sind für die Schrauben 36 vorgesehen. Nur die linke der beiden Schrauben 36 ist mit Bezugszeichen versehen. Die gesamte Elektrode 31 aus den Platten und dem Halter 39 wird mit Hilfe von Keramikhaltern 52, wie in Figur 4 gezeigt, in der Plasmakammer befestigt.

Die Gasverteilerplatten 32 bis 34 ermöglichen eine homogene Gasverteilung im Plasmaraum (oberhalb in der Figur). Durch eine ansteigende Anzahl von Gasverteilungslöchern je Gasverteilerplatte von unten nach oben in der Figur wird das notwendige Druckgefälle erreicht. Dadurch strömt das Gas homogen aus der obersten Platte 32 in die Plasmakammer darüber. Das Gas wird hierzu zunächst in den unterhalb von Platte 34 angeordneten Bereich eingeleitet. Der Trichter in der optischen Durchführung verhindert den Gasaustritt durch die optische Durchführung und hält diese gasdicht.

Der Winkel des Konus und die Größe der Durchführung 35 durch das Lochraster der Gasverteilerplatten ist durch die drei Gasverteilerplatten selbst vorgegeben. Diese sollte durch die Durchführung 35 möglichst wenig verändert werden. Der Durchmesser der oberen Öffnung der Durchführung im Konus beträgt 1 cm, der Durchmesser der unteren Öffnung beträgt 2,2 cm.

Die konische Durchführung wurde gewählt, um bei einer kleinen Öffnung in der oberen Elektrode einen möglichst großen Akzeptanzwinkel zur Sammlung der elektromagnetischen Strahlung zu realisieren. In vorliegenden Fall hat die Gasduschenelektrode einen Durchmesser von 13,7 cm. Industriell werden aber mittlerweile Substratgrößen von bis zu 5,7 m² beschichtet. Auch muss das Substrat nicht oberhalb der Elektrode 32 angeordnet sein. Die Showerheadelektrode kann auch oberhalb des Substrates sein. Dies entspricht einem "auf den Kopf stellen" der Anordnung in Figur 2. Auch können Elektrode und Gegenelektrode vertikal angeordnet sein. Dies entspricht einer Kippung um 90 °.

Figur 3 zeigt schematisch die Anordnung in einer erfindungsgemäßen Vakuumkammer 41. Durch die Anordnung der Turbopumpe 47 in diesem Beispiel ist eine lineare Strahlführung nicht möglich, deswegen ist die 45 °-Umlenkung durch den Spiegel 46 nötig. Der Abstand von der erfindungsgemäßen rf-Elektrode 44 und damit der Abstand der Linse 45 zum Substrat 43 ist höhenverstellbar und variabel von etwa 5 mm bis etwa 25 mm einstellbar. Das entspricht den in der Industrie für die Abscheidung von Silizium während des PECVD-Verfahrens eingesetzten Abständen. Bezugszeichen 42 bezeichnet die Gegenelektrode, an der das Substrat 43 angeordnet ist. Ein nicht dargestellter Anregungslaser erzeugt die Strahlung 48, welche durch ein Fenster 50 in der Kammerwand und über die Sammellinse 45 auf das Substrat bzw. eine darauf abgeschiedene Schicht fokussiert wird. Bezugszeichen 49 zeigt die durch die Linse gesammelte (Raman-)Strahlung, welche durch die Linse 45 auf den Spiegel 46 geführt wird. Vom Spiegel 46 wird die Strahlung 49 zur weiteren Analyse an das Spektrometer (nicht dargestellt) zugeführt. Der Einfallswinkel beträgt Null Grad.

Figur 4 zeigt die praktische Ausführung zu Figur 3 im technischen Schnitt. Die Plankonvexe Sammellinse 56 dient zum Fokussieren der Anregungsstrahlung auf die Probe und zum Sammeln der Raman-Strahlung (nicht dargestellt). Die Brennweite der Linse 56 ist so gewählt, dass die Substratoberfläche im Brennpunkt liegt (hier 38 mm). Die Linse 56 ist mit einer Schraube 55 in der Halterung geklemmt.

Das Glasplättchen 60 über der Linse 56 wurde eingebaut, um die Beschichtung der Linse während der Abscheidung der Probenschicht (nicht dargestellt) zu verhindern. Es ermöglicht vorteilhaft eine einfache Reinigung der Optik. Die optische Durchführung ist in dieser Figur nicht dargestellt. Zum Auskoppeln und Einkoppeln der Strahlung ist ein Spiegel 61 in 45° Winkel zur Halterung angeordnet.

Der Spiegel 61 ist gemeinsam mit der Linse 56 in einem Halter angeordnet. Dieser Halter 53 ist höhenverstellbar an der Elektrode befestigt, um verschiedene Abstände zwischen Elektrode und Schicht sowie die Schicht selbst variabel spektroskopieren zu können. Die Höhenverstellbarkeit wird durch eine Schraube in einem Langloch gewährleistet (in dieser Zeichnung nicht zu sehen).

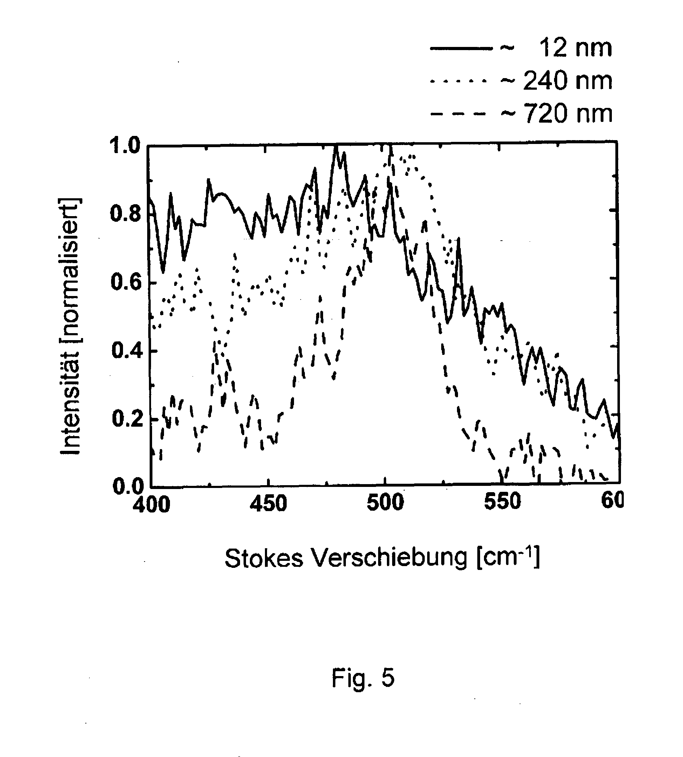

Figur 5 zeigt die durch den erfindungsgemäßen Aufbau aus Elektrode mit optischer Durchführung und Anordnung in der Plasmakammer erfolgte in situ-Messung der Intenität der Stokes-Verschiebung in Abhängigkeit von der Größe der Verschiebung als Basis einer Raman-Spektroskopie. Gezeigt werden Messungen in verschiedenen Stadien der Schichtabscheidung. Nach ca. 12 nm abgeschiedener Silizium Schicht ist ein Signal zu erkennen, welches dem Glasuntergrund zugeordnet werden kann. Nach ca. 240 nm zeigt das Messsignal eine für mikrokristallines Silizium typische Charakteristik. Die Stokes Verschiebung von mikrokristallinem Silizium kann in zwei Anteile zerlegt werden. Der erste Teil wird von der mikrokristallinen Phase hervorgerufen und hat sein Intensitätsmaxium bei ∼520 cm⁻¹. Der zweite Teil wird von der amorphen Phase hervorgerufen. Sein Intensitätsmaximum liegt bei ~ 480 cm⁻¹. Da die Abscheidung bei etwa 200 °C stattfindet, liegt das Intensitätsmaxium der mikrokristallinen Phase bei einer Stokes-Verschiebung von etwa 505 relativen Wellenzahlen, das der amorphen bei ~460 cm⁻¹. Bei einer Dicke der abgeschiedenen Schicht von etwa 720 nm ist das Signal noch deutlicher ausgeprägt, weil der Beitrag des Glasuntergrunds nun vollständig unterdrückt wird.

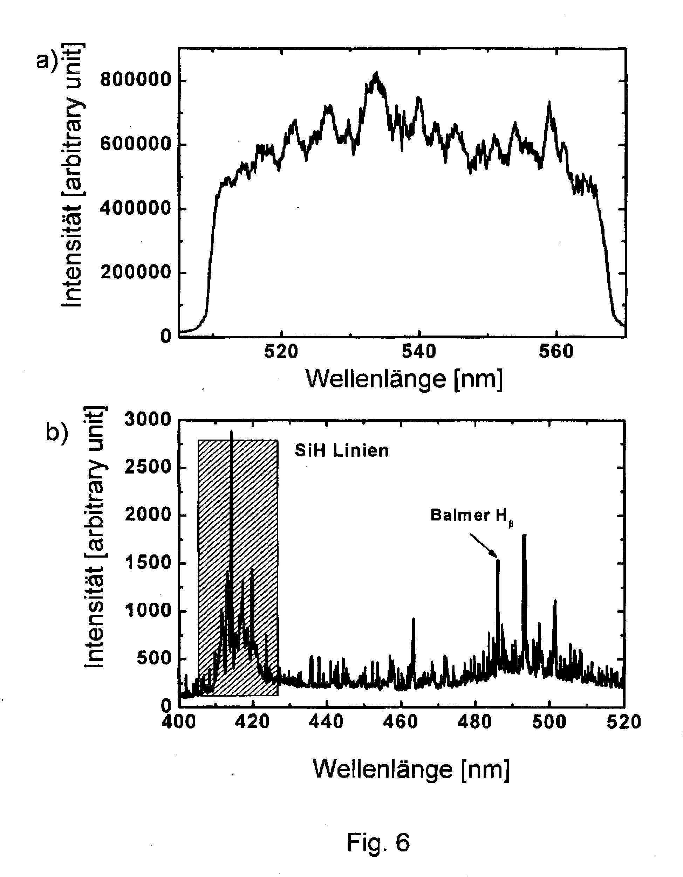

Figur 6a) zeigt die durch den erfindungsgemäßen Aufbau aus Elektrode mit optischer Durchführung und Anordnung in der Plasmakammer erfolgte in situ-Messung der Intensität der optischen Emission des Plasmas in Abhängigkeit von der Wellenlänge in einem Bereich von 505 nm bis 570 nm. Misst man in einem größeren Spektralbereich, wie in Figur 6b) dargestellt, kann man z. B. das Verhältnis zweier Emissionslinien benutzen um Gaskonzentrationen im Plasma zu bestimmen.

## Patentansprüche

1. rf-Elelcttode für die Erzeugung eines Plasmas in einer Plasmakammer,
mit mindestens einer optischen Durchführung, wobei die rf-Elektrode eine Gasdusche ist, **gekennzeichnet durch** einen konischen Trichter, der die optische Durchführung der Gasdusche gasdicht auskleidet.

2. Elektrode nach Anspruch 1,
**Dadurch gekennzeichnet, dass**
die optische Durchführung so groß ist, dass durch die rf-Elektrode hindurch eine in situ Raman-Spektroskopie oder eine optische Emissionsspektroskopie durchgeführt werden kann.

3. Elektrode nach einem der vorhergehenden Ansprüche
**gekennzeichnet durch**
einen konischen Schnitt der optischen Durchführung.

4. Elektrode nach vorherigem Anspruch,
bei dem
die kleinere der beiden Öffnungen der Durchführung eine Fläche von 0,03 cm² bis 5 cm² aufweist.

5. Elektrode nach einem der beiden vorherigen Ansprüche,
bei dem
die größere der beiden Öffnungen der Durchführung eine Fläche von 0,031 bis 100 cm² aufweist.

6. Elektrode nach einem der vorhergehenden Ansprüche,
**dadurch gekennzeichnet, dass**
eine Öffnung der optischen Durchführung eine Schirmung aufweist.

7. Elektrode nach vorherigem Anspruch,
**gekennzeichnet durch**
ein metallisches Gitter als Schirmung der optischen Durchführung, welches auf der Öffnun der optischen Durchführung angeordnet ist.

8. Elektrode nach einem der vorhergehenden Ansprüche,
**gekennzeichnet durch**
eine Sammellinse.

9. Elektrode nach vorherigem Anspruch,
**dadurch gekennzeichnet, dass**
zwischen der Sammellinse und der Öffnung der optischen Durchführung ein Glasplättchen zum Schutz der Sammellinse vor einem Gas in der Plasmakammer angeordnet ist.

10. Elektrode nach vorherigem Anspruch,
**dadurch gekennzeichnet, dass**
in der Gasdusche mehr als eine Gasverteilerplatte angeordnet ist

11. Plasmakammer, umfassend eine rf-Elektrode und eine Gegenelektrode mit einem Substrathalter zur Ausnahme eines Substrats, wobei zwischen der rf-Elektrode und der Gegenelektrode ein Hochfrequenzwechselfeld zur Erzeugung des Plasmas ausgebildet werden kann,
**gekennzeichnet durch**
eine rf-Elektrode nach einem der vorhergehenden Ansprüche.

12. Plasmakammer nach vorherigem Anspruch,
**gekennzeichnet durch**
eine rf-Elektrode nach einem der Ansprüche 1 bis 7, wobei eine konvexe Sammellinse in der Plasmakammer angeordnet elektromagnetische Strahlung **durch** die optische Durchführung auf die Schicht oder auf das Plasma fokussieren kann, und **durch** die optische Durchführung hindurch gestreute oder reflektierte oder von der Schicht oder dem Plasma emittierte Strahlung zum Zwecke der Analyse der gestreuten oder reflektierten oder emittierten Strahlung parallelisiert und einem Analysegerät zuführen kann.

13. Plasmakammer nach vorherigem Anspruch,
**gekennzeichnet durch**
eine im Strahlengang der Plasmakammer verschiebbare Sammellinse.

14. Verfahren zur in situ-Analyse oder in situ-Bearbeitung einer Schicht oder eines Plasmas in einer Plasmakammer nach einem der vorhergehenden drei Ansprüche, wobei die Schicht auf einer Gegenelektrode angeordnet ist und auf der der Schicht zugewandten Seite eine rf-Elektrode angeordnet ist,
**gekennzeichnet durch**
Wahl einer rf-Elektrode nach einem der vorhergehenden Ansprüche 1 bis 10, und **durch** mindestens einen Schritt, bei dem elektromagnetische Strahlung aus der Plasmakammer **durch** die optische Durchführung der rf-Elektrode einem Analysegerät zugeführt wird.

15. Verfahren nach vorherigem Anspruch,
**dadurch gekennzeichnet, dass**
eine in situ-Raman-Spektroskopie der wachsenden Schicht oder eine optische Emissionsspektroskopie des Plasmas erfolgt, wobei die elektromagnetische Strahlung über eine Sammellinse dem Analysegerät zugeführt wird.

## Claims

1. RF electrode for generating a plasma in a plasma chamber, comprising at least one optical feed-through, wherein the RF electrode is a gas showerhead, **characterised by** a conical funnel that lines the optical feed-through of the gas showerhead in a gas-tight manner.

2. Electrode according to claim 1, **characterised in that** the optical feed-through is large enough to allow in situ Raman spectroscopy or optical emission spectroscopy to be carried out through the RF electrode.

3. Electrode according to one of the preceding claims, **characterised by** a conical section for the optical feed-through.

4. Electrode according to the preceding claim, in which the smaller of the two openings of the feed-through has an area of 0.03 cm² to 5 cm².

5. Electrode according to one of the two preceding claims, in which the larger of the two openings of the feed-through has an area of 0.031 to 100 cm².

6. Electrode according to one of the preceding claims, **characterised in that** one opening of the optical feed-through comprises a screen.

7. Electrode according to the preceding claim, **characterised by** a metallic mesh as the screen for the optical feed-through, said metallic mesh being arranged on the opening of the optical feed-through.

8. Electrode according to one of the preceding claims, **characterised by** a converging lens.

9. Electrode according to the preceding claim, **characterised in that** a sheet of glass is arranged between the converging lens and the opening of the optical feed-through in order to protect the converging lens from a gas in the plasma chamber.

10. Electrode according to the preceding claim, **characterised in that** more than one gas distributor plate is arranged in the gas showerhead.

11. Plasma chamber, including an RF electrode and a counter electrode with a substrate holder for receiving a substrate, wherein a high-frequency alternating field for generating the plasma can be formed between the RF electrode and the counter electrode, **characterised by** an RF electrode according to one of the preceding claims.

12. Plasma chamber according to the preceding claim, **characterised by** an RF electrode according to one of claims 1 to 7, wherein a convex converging lens arranged in the plasma chamber can focus electromagnetic radiation through the optical feed-through on to the layer or on to the plasma and radiation scattered or reflected through the optical feed-through or emitted by the layer or the plasma can be parallelised and fed to an analyser for the purposes of analysing the scattered or reflected or emitted radiation.

13. Plasma chamber according to the preceding claim, **characterised by** a converging lens displaceable in the beam path of the plasma chamber.

14. Method for the in situ analysis or in situ processing of a layer or a plasma in a plasma chamber according to one of the preceding three claims, wherein the layer is arranged on a counter electrode and an RF electrode is arranged on the side directed towards the layer, **characterised by** the selection of an RF electrode according to one of the preceding claims 1 to 10 and by at least one step in which electromagnetic radiation is fed from the plasma chamber through the optical feed-through of the RF electrode to an analyser.

15. Method according to the preceding claim, **characterised in that** in situ Raman spectroscopy of the growing layer or optical emission spectroscopy of the plasma is performed, wherein the electromagnetic radiation is fed to the analyser via a converging lens.

## Revendications

1. Electrode RF servant à produire un plasma dans une chambre à plasma,
comprenant au moins un passage optique, sachant que l'électrode RF est une douche à gaz, **caractérisée par** un entonnoir conique, qui habille de manière étanche au gaz le passage optique de la douche à gaz.

2. Electrode selon la revendication 1,
**caractérisée en ce**
**que** le passage optique présente une telle dimension qu'il est possible d'effectuer, à travers l'électrode RF, une spectroscopie Raman in situ ou une spectroscopie d'émission optique.

3. Electrode selon l'une quelconque des revendications précédentes,
**caractérisée par**
une coupe conique du passage optique.

4. Electrode selon la revendication précédente,
dans laquelle
la plus petite des deux ouvertures du passage présente une surface allant de 0,03 cm² à 5 cm².

5. Electrode selon l'une quelconque des deux revendications précédentes,
dans laquelle
la plus grande des deux ouvertures du passage présente une surface allant de 0,031 cm² à 100 cm².

6. Electrode selon l'une quelconque des revendications précédentes,
**caractérisée en ce**
**qu'**une ouverture du passage optique présente un blindage.

7. Electrode selon la revendication précédente,
**caractérisée par**
un grillage métallique faisant office de blindage du passage optique, ledit grillage métallique étant disposé sur l'ouverture du passage optique.

8. Electrode selon l'une quelconque des revendications précédentes,
**caractérisée par**
une lentille de convergence.

9. Electrode selon la revendication précédente,
**caractérisée en ce**
**qu'**une petite plaque de verre servant à protéger la lentille de convergence contre un gaz est disposée dans la chambre à plasma entre la lentille de convergence et l'ouverture du passage optique.

10. Electrode selon la revendication précédente,
**caractérisée en ce**
**que** plus d'une plaque de distribution de gaz est disposée dans la douche à gaz.

11. Chambre à plasma, comprenant une électrode RF et une contre-électrode pourvue d'un support de substrat servant à recevoir un substrat, sachant qu'un champ alternatif à haute fréquence servant à produire le plasma peut être réalisé entre l'électrode RF et la contre-électrode,
**caractérisée par**
une électrode RF selon l'une quelconque des revendications précédentes.

12. Chambre à plasma selon la revendication précédente,
**caractérisée par**
une électrode RF selon l'une quelconque des revendications 1 à 7, sachant qu'une lentille de convergence convexe, dans la chambre à plasma, peut concentrer un rayonnement électromagnétique par le passage optique sur la couche ou sur le plasma, et parallélise et peut amener à un appareil d'analyse, à travers le passage optique, un rayonnement diffus ou réfléchi ou émis par la couche ou par le plasma aux fins de l'analyse du rayonnement diffus ou réfléchi ou émis.

13. Chambre à plasma selon la revendication précédente,
**caractérisée par**
une lentille de convergence pouvant être déplacée par coulissement dans la trajectoire des rayons de la chambre à plasma.

14. Procédé d'analyse in situ ou de traitement in situ d'une couche ou d'un plasma dans une chambre à plasma selon l'une quelconque des trois revendications précédentes, sachant que la couche est disposée sur une contre-électrode et qu'une électrode RF est disposée sur le côté tourné vers la couche,
**caractérisé par**
la sélection d'une électrode RF selon l'une quelconque des revendications 1 à 10, et
par au moins une étape lors de laquelle un rayonnement électromagnétique en provenance de la chambre à plasma est amené à un appareil d'analyse par le passage optique de l'électrode RF.

15. Procédé selon la revendication précédente,
**caractérisé en ce**
**qu'**une spectroscopie Raman in situ de la couche en croissance ou une spectroscopie d'émission optique du plasma a lieu, sachant que le rayonnement électromagnétique est amené, par l'intermédiaire d'une lentille de convergence, à l'appareil d'analyse.
